(19) Europäisches Patentamt / European Patent Office / Office européen des brevets

(11) **EP 3 905 350 A1**

(12) **EUROPEAN PATENT APPLICATION**
published in accordance with Art. 153(4) EPC

(43) Date of publication:
**03.11.2021 Bulletin 2021/44**

(51) Int Cl.:
*H01L 35/14* (2006.01)　　　*C01B 33/06* (2006.01)
*C04B 35/58* (2006.01)

(21) Application number: **19906246.4**

(22) Date of filing: **12.11.2019**

(86) International application number:
**PCT/JP2019/044313**

(87) International publication number:
**WO 2020/137205 (02.07.2020 Gazette 2020/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.12.2018 JP 2018242588**

(71) Applicant: **Mitsubishi Materials Corporation Tokyo 100-8117 (JP)**

(72) Inventor: **NAKADA Yoshinobu Saitama-shi, Saitama 330-8508 (JP)**

(74) Representative: **Hoffmann Eitle Patent- und Rechtsanwälte PartmbB Arabellastraße 30 81925 München (DE)**

(54) **THERMOELECTRIC CONVERSION MATERIAL, THERMOELECTRIC CONVERSION ELEMENT AND THERMOELECTRIC CONVERSION MODULE**

(57) A thermoelectric conversion material made of a sintered body containing a magnesium silicide as a major component includes: a magnesium silicide phase (12); and a magnesium oxide layer (13) formed on a surface layer of the magnesium silicide phase (12), in which an aluminum concentrated layer (14) having an Al concentration higher than an aluminum concentration in an inside of the magnesium silicide phase (12) is formed between the magnesium oxide layer (13) and the magnesium silicide phase (12), and the aluminum concentrated layer (14) has a metallic aluminum phase (15) including aluminum or an aluminum alloy.

FIG. 2

**Description**

[Technical Field]

The present invention relates to a thermoelectric conversion material made of a sintered body containing a magnesium silicide as a major component, a thermoelectric conversion element, and a thermoelectric conversion module.
Priority is claimed on Japanese Patent Application No. 2018-242588, filed December 26, 2018, the content of which is incorporated herein by reference.

[Background Art]

A thermoelectric conversion element including a thermoelectric conversion material is an electronic element capable of mutually converting heat and electricity, as in Seebeck effect and Peltier effect. The Seebeck effect is an effect of converting heat energy into electric energy, and is a phenomenon in which an electromotive force is generated when a temperature difference is generated between both ends of a thermoelectric conversion material. Such an electromotive force depends on properties of the thermoelectric conversion material. In recent years, thermoelectric power generation utilizing the effect is actively developed.
The thermoelectric conversion element described above has a structure in which electrodes are each formed on one end side and the other end side of the thermoelectric conversion material.
As an index representing a property of the thermoelectric conversion element (thermoelectric conversion material), for example, a power factor (PF) represented by Equation (1) below or a dimensionless figure of merit (ZT) represented by Equation (2) below is used. In the thermoelectric conversion material, it is necessary to maintain a temperature difference between one surface side and the other surface side. Therefore, it is preferable that the thermoelectric conversion material has a low thermal conductivity.

$$PF = S^2\sigma \cdots (1)$$

Here, S: Seebeck coefficient (V/K), $\sigma$: Electric conductivity (S/m)

$$ZT = S^2\sigma T/\kappa \cdots (2)$$

Here, T = Absolute temperature (K), $\kappa$ = Thermal conductivity (W/(m $\times$ K))
As the thermoelectric conversion material described above, for example, as shown in Patent Literature 1, a material obtained by adding various dopants to magnesium silicide is proposed.
Here, the thermoelectric conversion material including the magnesium silicide tends to be easily oxidized, and there is a concern that the oxidation may cause deterioration of thermoelectric properties or the element may become brittle.
Therefore, in Patent Literature 2 described above, a technique for preventing oxidation of a thermoelectric conversion material by covering the thermoelectric conversion material with glass is proposed.

[Citation List]

[Patent Literature]

[Patent Literature 1]
Japanese Unexamined Patent Application, First Publication No. 2013-179322
[Patent Literature 2]
Japanese Unexamined Patent Application, First Publication No. 2017-050325

[Summary of Invention]

[Technical Problem]

Meanwhile, as shown in Patent Literature 2, in a case where a thermoelectric conversion material is covered with glass, the glass peels off due to a difference in a thermal expansion coefficient between the thermoelectric conversion material and the glass, and there is a concern that oxidation of the thermoelectric conversion material cannot be suppressed. In addition, it is necessary to cover an entire surface of the thermoelectric conversion material forming each thermoelectric conversion element with glass, thereby increasing manufacturing costs, which was a problem.

Here, in order to suppress the oxidation of the thermoelectric conversion material, it is conceivable to house a module incorporating the thermoelectric conversion material in a container which is vacuumed or filled with an inert gas.

However, in this case, there is a concern that the manufacturing costs may increase in order to secure strength of the container.

Furthermore, in a case where the container is made of stainless steel, a thermal conductivity of the stainless steel is lower comparing to a thermal conductivity of copper or aluminum, and a heat transfer to an element becomes poor, resulting in heat loss. Also, even in a case where the container is formed to have a large wall thickness in order to secure the strength of the container, the thermal conductivity becomes insufficient. Therefore, there is a concern that a thermoelectric conversion efficiency of the thermoelectric conversion module may be lowered.

The present invention has been made in view of the above circumstances, and an objective thereof is to provide: a thermoelectric conversion material which is formed of a sintered body containing a magnesium silicide as a major component, has an excellent oxidation resistance, and is capable of forming a thermoelectric conversion module having an excellent thermoelectric conversion efficiency; and a thermoelectric conversion element and a thermoelectric conversion module which use the thermoelectric conversion material.

[Solution to Problem]

In order to solve the above objective, a thermoelectric conversion material of the present invention including a sintered body containing a magnesium silicide as a major component includes: a magnesium silicide phase; and a magnesium oxide layer formed on a surface layer of the magnesium silicide phase, in which an aluminum concentrated layer having an Al concentration higher than an aluminum concentration in an inside of the magnesium silicide phase is formed between the magnesium oxide layer and the magnesium silicide phase, and the aluminum concentrated layer has a metallic aluminum phase made of aluminum or an aluminum alloy.

According to the thermoelectric conversion material having the configuration, the aluminum concentrated layer having an Al concentration higher than an aluminum concentration of the inside of the magnesium silicide phase is formed between the magnesium oxide layer and the magnesium silicide phase, and the aluminum concentrated layer has a metallic aluminum phase made of aluminum or an aluminum alloy. Therefore, with the aluminum concentrated layer, invasion of oxygen into the magnesium silicide phase can be suppressed and an oxidation of the magnesium silicide phase can be suppressed.

Therefore, it is possible to provide a thermoelectric conversion material having excellent oxidation resistance and stable properties. In addition, since the thermoelectric conversion material has excellent oxidation resistance, it is not necessary to house a thermoelectric conversion module incorporating the thermoelectric conversion element in a container, thermal conductivity can be secured, and a thermoelectric conversion module having excellent thermoelectric conversion efficiency can be configured.

The metallic aluminum phase is formed of aluminum or an aluminum alloy (including one or two of Al, Mg, and Si).

Here, in the thermoelectric conversion material of the present invention, a thickness of the aluminum concentrated layer is preferably within a range of 10 nm or more and 100 nm or less.

In this case, since the thickness of the aluminum concentrated layer is 10 nm or more, the invasion of oxygen to the inside of the magnesium silicide phase can be reliably suppressed by the aluminum concentrated layer. On the other hand, since the thickness of the aluminum concentrated layer is 100 nm or less, the aluminum concentrated layer does not increase a thermal conductivity of an entire thermoelectric element and the thermal conductivity of a main constituent element can be maintained. Therefore, it is possible to prevent a dimensionless figure of merit ZT from decreasing.

In addition, in the thermoelectric conversion material of the present invention, the magnesium silicide phase may be formed of a non-doped magnesium silicide.

In this case, the magnesium silicide phase is formed of the non-doped magnesium silicide having no dopant, but a $Mg_2Si$ phase is stable and has an n-type having high ZT due to a small amount of Al diffused to the $Mg_2Si$ phase. Therefore, it is not necessary to use various dopant elements that are complicated to handle, and a production efficiency is improved.

Here, the non-doped magnesium silicide having no dopant indicates that a content of a dopant element (for example, Li, Na, K, B, Ga, In, N, P, As, Sb, Bi, Ag, Cu, and Y) which is an impurity added to prepare a thermoelectric material is $1.0 \times 10^{18}$ atoms/cm$^3$ or less.

Alternatively, in the thermoelectric conversion material of the present invention, the magnesium silicide phase may contain, as a dopant, one or more selected from Li, Na, K, B, Ga, In, N, P, As, Sb, Bi, Ag, Cu, and Y.

In this case, the thermoelectric conversion material can have a specific semiconductor type, that is, an n-type thermoelectric conversion material or a p-type thermoelectric conversion material.

A thermoelectric conversion element of the present invention includes the thermoelectric conversion material described above, and electrodes respectively joined to one surface and the other surface of the thermoelectric conversion material.

According to the thermoelectric conversion element having the configuration, since the thermoelectric conversion material having excellent oxidation resistance is provided, various properties are stabilized. Therefore, a thermoelectric conversion performance is stable and a reliability is excellent.

According to still another aspect of the present invention, a thermoelectric conversion module includes the thermoelectric conversion element described above; and terminals respectively joined to the electrodes of the thermoelectric conversion element.

According to the thermoelectric conversion module having the configuration, since the thermoelectric conversion element described above is provided, a thermoelectric conversion material has an excellent oxidation resistance and various properties are stabilized. Therefore, the thermoelectric conversion performance is stable and the reliability is excellent.

[Advantageous Effects of Invention]

According to the present invention, it is possible to provide: a thermoelectric conversion material which is formed of a sintered body containing a magnesium silicide as a major component, has an excellent oxidation resistance, and is capable of forming a thermoelectric conversion module having an excellent thermoelectric conversion efficiency; and a thermoelectric conversion element and a thermoelectric conversion module which use the thermoelectric conversion material.

[Brief Description of Drawings]

Fig. 1 is a sectional view showing a thermoelectric conversion material according to an embodiment of the present invention, a thermoelectric conversion element, and a thermoelectric conversion module.
Fig. 2 is an explanatory view showing a thermoelectric conversion material according to the embodiment of the present invention.
Fig. 3 is a graph showing an example of an XPS analysis of the thermoelectric conversion material according to the embodiment of the present invention.
Fig. 4 is a flowchart showing a method for manufacturing a thermoelectric conversion material according to the embodiment of the present invention.
Fig. 5 is a sectional view showing an example of a sintering apparatus used in the method for manufacturing a thermoelectric conversion material according to the embodiment of the present invention.

[Description of Embodiments]

Hereinafter, a thermoelectric conversion material according to an embodiment of the present invention, a thermoelectric conversion element, and a thermoelectric conversion module will be described with reference to the accompanying drawings. Each embodiment to be described below is specifically described for better understanding of the gist of the invention, and does not limit the present invention unless otherwise specified. In addition, in the drawings used in the following description, for convenience, in order to make the features of the present invention easy to understand, a portion that is a main part may be enlarged in some cases, and a dimensional ratio or the like of each component is not always the same as an actual one.

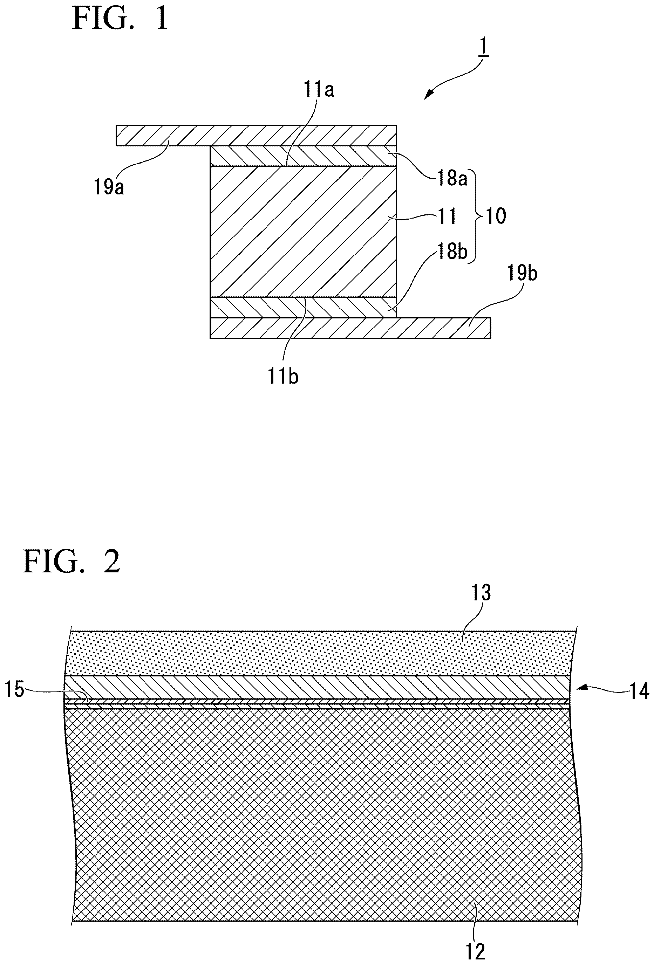

Fig. 1 shows a thermoelectric conversion material 11 according to an embodiment of the present invention, a thermoelectric conversion element 10 using the thermoelectric conversion material 11, and a thermoelectric conversion module 1.

The thermoelectric conversion element 10 includes the thermoelectric conversion material 11 according to the present embodiment, and electrodes 18a and 18b respectively formed on one surface 1 1a and the other surface 11b of the thermoelectric conversion material 11.

In addition, the thermoelectric conversion module 1 includes terminals 19a and 19b respectively joined to the electrodes 18a and 18b of the thermoelectric conversion element 10 described above.

For the electrodes 18a and 18b, nickel, silver, cobalt, tungsten, molybdenum, or the like is used. The electrodes 18a and 18b can be formed by electric sintering, plating, electrodeposition, or the like.

The terminals 19a and 19b are formed of a metal material excellent in conductivity, for example, a plate material such as copper or aluminum. In the present embodiment, a rolled aluminum plate is used. In addition, the thermoelectric conversion material 11 (the electrodes 18a and 18b) and the terminals 19a and 19b can be respectively joined together, by Ag brazing, Ag plating, or the like.

Moreover, the thermoelectric conversion material 11 of the present embodiment includes a sintered body containing a magnesium silicide as a main component.

The thermoelectric conversion material 11 may be formed of the non-doped magnesium silicide having no dopant, and may be formed of a magnesium silicide containing, as a dopant, one or more selected from Li, Na, K, B, Ga, In, N, P, As, Sb, Bi, Ag, Cu, and Y.

Here, this means that a content of the magnesium silicide in the sintered body containing the magnesium silicide as a main component is 90% by mass or more.

The content of the magnesium silicide can be directly obtained from the sintered body as an object by an existing analysis method (for example, electron micro analyzer (EPMA) method and powder X-ray diffraction method). Furthermore, among the compounds (or elements) contained in a raw material powder used for preparing the sintered body, the content can also be indirectly derived from a mass% of $Mg_2Si$ with respect to those excluding the elements lost from the sintered body under sintering conditions (for example, $Mg_2Si$, Sb, and Al).

In the present embodiment, the thermoelectric conversion material 11 is formed by adding antimony (Sb) as a dopant to the magnesium silicide ($Mg_2Si$). For example, the thermoelectric conversion material 11 of the present embodiment has a composition in which the antimony is added in a range of 0.1 at% or more and 2.0 at% or less to $Mg_2Si$. In the thermoelectric conversion material 11 of the present embodiment, an n-type thermoelectric conversion material having a high carrier density is obtained by adding the antimony which is a pentavalent donor.

Here, as the donor for obtaining the n-type thermoelectric conversion element from the thermoelectric conversion material 11, bismuth, phosphorus, arsenic, and the like can be used in addition to the antimony.

Furthermore, the thermoelectric conversion material 11 may be formed to be a p-type thermoelectric conversion element. In this case, the p-type thermoelectric conversion element can be obtained by adding a dopant such as lithium or silver as an acceptor.

Moreover, as shown in Fig. 2, the thermoelectric conversion material 11 of the present embodiment includes: a magnesium silicide phase 12 including the magnesium silicide (Sb-doped $Mg_2Si$) described above; a magnesium oxide layer 13 formed on the surface layer of the magnesium silicide phase 12; and an aluminum concentrated layer 14 which is formed between the magnesium silicide phase 12 and the magnesium oxide layer 13 and has an Al concentration higher than an aluminum concentration in an inside of the magnesium silicide phase 12.

In addition, the aluminum concentrated layer 14 has a metallic aluminum phase 15 including aluminum or an aluminum alloy.

The aluminum concentrated layer 14 described above may have an aluminum oxide phase including aluminum oxide and an aluminum alloy oxide phase including aluminum alloy oxide, in addition to the metallic aluminum phase 15 including aluminum or an aluminum alloy.

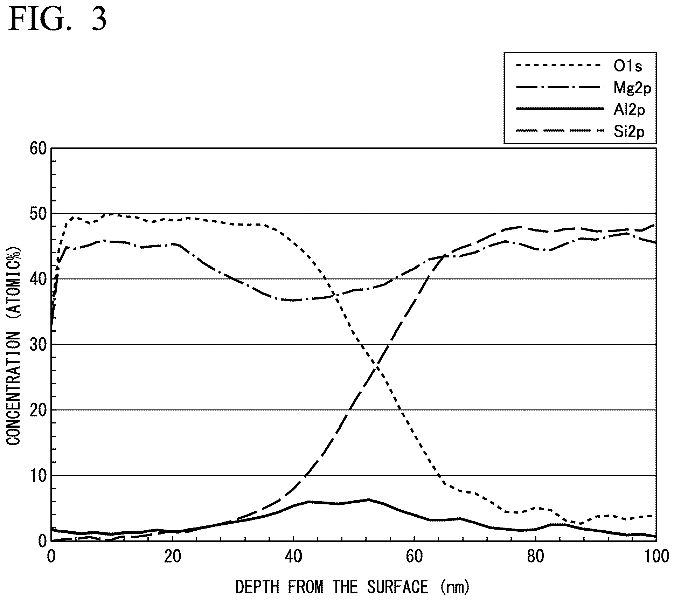

Fig. 3 shows results of XPS analysis of the thermoelectric conversion material 11 according to the present embodiment. A horizontal axis in Fig. 3 is a sputtering depth, which corresponds to a depth from a surface layer (an outermost surface of the magnesium oxide layer 13). A vertical axis is an atomic concentration.

Immediately after a start of sputtering (that is, the outermost layer portion), a region having a high concentration of magnesium and oxygen (magnesium oxide layer 13) is formed.

According to XPS analysis, an oxygen concentration in the magnesium oxide layer 13 is 45 at% or higher, a magnesium concentration is 40 at% or higher, an Al concentration is 1.5 at% or lower, and a silicon concentration is 1.0 at% or lower.

Thereafter, when a sputtering time progresses, there is a region where the oxygen concentration decreases in one direction and the silicon concentration increases in one direction. In this region, the aluminum concentration increases (1.5 times or more the Al concentration at a position at depth of 500 nm from the surface layer (corresponding to an inside of the magnesium silicide phase)), which corresponds to the aluminum concentrated layer 14 described above.

The oxygen concentration in the aluminum concentrated layer 14 obtained by XPS analysis decreases from 48 at% to 3.0 at% in one direction from the surface layer to the inside, the magnesium concentration is maintained in the range of 36 at% to 45 at%, the silicon concentration increases from 2 at% to 48 at% in one direction from the surface layer to the inside.

As the sputtering time further progresses, a region where the oxygen concentration was maintained at 5 at% or lower, the silicon concentration and the magnesium concentration are maintained at 45 at% or higher, and the aluminum concentration decreases less than 1.5 times the Al concentration at a position at a depth of 500 nm from the surface layer. This region becomes the magnesium silicide phase 12.

In addition, in the present embodiment, the thickness of the aluminum concentrated layer 14 is preferably within a range of 10 nm or more and 100 nm or less.

A lower limit of the thickness of the aluminum concentrated layer 14 is further preferably 20 nm or more, and more preferably 30 nm or more. An upper limit of the thickness of the aluminum concentrated layer 14 is further preferably 90 nm or less, and more preferably 80 nm or less.

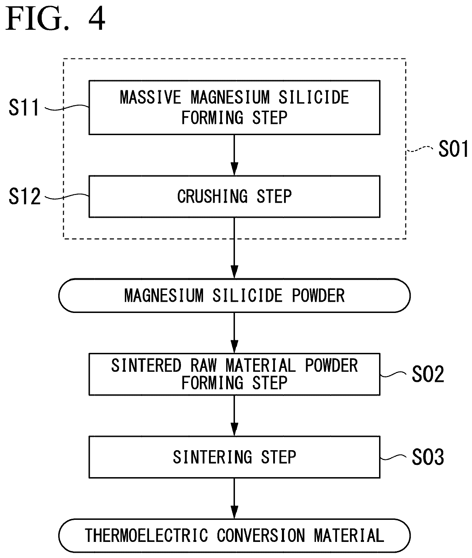

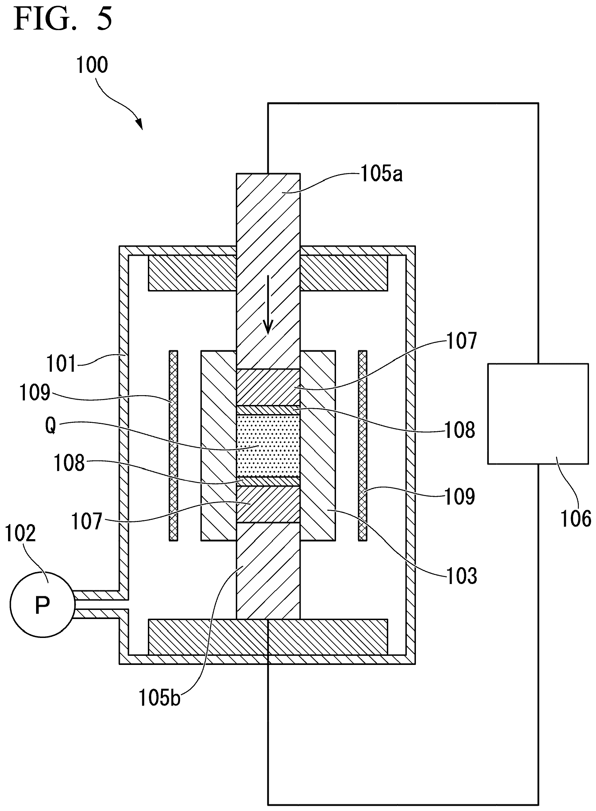

Hereinafter, a method for manufacturing the thermoelectric conversion material 11 according to the present embodiment will be described with reference to Figs. 4 and 5.

(Magnesium silicide powder preparation step S01)

First, a powder of a magnesium silicide ($Mg_2Si$), which is a matrix of the sintered body of the thermoelectric conversion material 11 is manufactured.

In the present embodiment, the magnesium silicide powder preparation step S01 includes a massive magnesium silicide forming step S11 for obtaining a massive magnesium silicide and a crushing step S12 for crushing the massive magnesium silicide ($Mg_2Si$) to obtain a powder.

In the massive magnesium silicide forming step S11, a silicon powder and a magnesium powder, and a dopant to be added as needed are weighed and mixed. For example, in a case of forming an n-type thermoelectric conversion material, a pentavalent material such as antimony or bismuth is mixed as a dopant. Also, in a case of forming a p-type thermoelectric conversion material, a material such as lithium or silver is mixed as a dopant. In addition, non-doped magnesium silicide may be used without adding a dopant.

In the present embodiment, antimony is used as a dopant in order to obtain an n-type thermoelectric conversion material, and the amount of antimony added is within a range of 0.1 at% or more and 2.0 at% or less.

Also, this mixed powder is introduced into, for example, an alumina crucible, heated to a range of 800°C or higher and 1150°C or lower, cooled and solidified. As a result, a massive magnesium silicide is obtained.

Since a small amount of magnesium sublimates during heating, it is preferable to add a large amount of magnesium, for example, approximately 3 at% to 5 at% of magnesium, to a stoichiometric composition of Mg:Si = 2:1 when measuring the raw materials.

In the crushing step S12, the obtained massive magnesium silicide is pulverized by a pulverizer to form a magnesium silicide powder.

Here, an average particle size of the magnesium silicide powder is preferably within a range of 1 $\mu$m or more and 100 $\mu$m or less.

With respect to the magnesium silicide powder to which a dopant is added, the dopant is uniformly present in the magnesium silicide powder.

In a case where a commercially available magnesium silicide powder or a magnesium silicide powder to which a dopant is added is used, the massive magnesium silicide forming step S11 and the crushing step S12 can be omitted.

(Sintering raw material powder forming step S02)

Next, the obtained magnesium silicide powder is mixed with a metallic aluminum powder to obtain a sintering raw material powder.

Here, a content of the metallic aluminum powder in the sintering raw material powder is preferably within a range of 0.01 mass% or more and 1.00 mass% or less.

Furthermore, as the metallic aluminum powder, it is preferable to use a powder having an aluminum purity of 99.0 mass% or higher.

Furthermore, an average particle size of the metallic aluminum powder is preferably within a range of 0.5 $\mu$m or more and 50 $\mu$m or less.

(Sintering step S03)

Next, the sintering raw material powder obtained as described above is heated while applying pressure to obtain a sintered body. In this sintering step S03, since the sintering raw material powder becomes a mixed powder of the magnesium silicide powder and the metallic aluminum powder, the metallic aluminum is present between the magnesium silicide powders, and the aluminum concentrated layer 14 having the metallic aluminum phase 15 is formed on the surface layer of the magnesium silicide phase 12. By reacting Al of the metallic aluminum powder with Mg and Si of magnesium silicide powder, an aluminum alloy containing one or two kinds of Al, Mg, and Si may be formed. Furthermore, the magnesium oxide layer 13 is formed by oxidizing a surface of the magnesium silicide powder.

Here, in the present embodiment, in the sintering step S03, a sintering apparatus (an electric sintering apparatus 100) shown in Fig. 5 is used.

The sintering apparatus (electric sintering apparatus 100) shown in Fig. 5 includes, for example, a pressure-resistant housing 101, a vacuum pump 102 for reducing the pressure inside the pressure-resistant housing 101, and a hollow tubular carbon mold 103 disposed on an inside of the pressure-resistant housing 101, a pair of electrode portions 105a and 105b for applying a current while pressing a sintering raw material powder Q with which the carbon mold 103 is filled, and a power supply device 106 for applying a voltage between the pair of electrode portions 105a and 105b. In addition, a carbon plate 107 and a carbon sheet 108 are respectively provided between the electrode portions 105a and 105b and the sintering raw material powder Q. In addition to these, a thermometer, a displacement gauge, and the like (which are not shown) are provided. In addition, in the present embodiment, a heater 109 is provided on an outer peripheral side of the carbon mold 103. The heater 109 is disposed on four sides so as to cover the entire surface of the carbon mold 103 on outer peripheral side. As the heater 109, a carbon heater, a nichrome wire heater, a molybdenum heater, a Kanthal wire heater, a high frequency heater, or the like can be used.

In a sintering step S03, first, the carbon mold 103 of the electric sintering apparatus 100 shown in Fig. 5 is filled with the sintering raw material powder Q. For example, the inside of the carbon mold 103 is covered with a graphite sheet or a carbon sheet. Then, a direct current is applied between the pair of electrode portions 105a and 105b by using the power supply device 106, and a direct current is applied to the sintering raw material powder Q. Accordingly, a temperature increases by self-heating. In addition, between the pair of electrode portions 105a and 105b, the electrode portion 105a on a movable side is caused to move toward the sintering raw material powder Q, and the sintering raw material powder Q is pressed at a predetermined pressure between the electrode portion 105a and the electrode portion 105b on a fixed side. In addition, the heater 109 is heated.

Accordingly, the sintering raw material powder Q is sintered by the self-heating of the sintering raw material powder Q, the heat from the heater 109, and the pressurizing.

In the present embodiment, sintering conditions in the sintering step S03 are as follows: a sintering temperature of the sintering raw material powder Q is in a range of 800°C or higher and 1020°C or lower, and a holding time at the sintering temperature is 5 minutes or shorter. In addition, pressing load is in a range of 20 MPa or more and 50 MPa or less.

In addition, an atmosphere in the pressure-resistant housing 101 may be an inert atmosphere such as an argon atmosphere or a vacuum atmosphere. When the vacuum atmosphere is set, the pressure may be set to 5 Pa or less.

Here, in a case where the sintering temperature of the sintering raw material powder Q is lower than 800°C, an oxide film formed on a surface of each powder of the sintering raw material powder Q cannot be sufficiently removed, a surface oxide film of the raw material powder itself remains at grain boundaries, and bonding between the raw material powders is insufficient, resulting in a low density of the sintered body. For these reasons, there is a concern that an electrical resistance of the obtained thermoelectric conversion material may increase.

On the other hand, in a case where the sintering temperature of the sintering raw material powder Q exceeds 1020°C, a decomposition of magnesium silicide proceeds in a short time, and there are concerns that the composition shifts, the electrical resistance increases, and the Seebeck coefficient decreases.

Therefore, in the present embodiment, the sintering temperature in the sintering step S03 is set within a range of 800°C or higher and 1020°C or lower.

A lower limit of the sintering temperature in the sintering step S03 is preferably 800°C or higher, and further preferably 900°C or higher. On the other hand, an upper limit of the sintering temperature in the sintering step S03 is preferably 1020°C or lower, and further preferably 1000°C or lower.

Also, in a case where the holding time at the sintering temperature exceeds 5 minutes, a decomposition of magnesium silicide proceeds, and there are concerns that the composition shifts, the electrical resistance increases, and the Seebeck coefficient decreases. Furthermore, there are concerns that the grains may become coarse and the thermal conductivity may increase.

Therefore, in the present embodiment, the holding time at the sintering temperature in the sintering step S03 is set to 5 minutes or shorter.

An upper limit of the holding time at the sintering temperature in the sintering step S03 is preferably 3 minutes or shorter, and further preferably 2 minutes or shorter.

Furthermore, in a case where the pressing load sin the sintering step S03 is less than 20 MPa, there are concerns that the density does not increase and the electrical resistance of the thermoelectric conversion material may increase.

On the other hand, in a case where the pressing load in the sintering step S03 exceeds 50 MPa, there are concerns that a force applied to the carbon jig is large and the jig may be broken.

Therefore, in the present embodiment, the pressing load in the sintering step S03 is set within a range of 20 MPa or more and 50 MPa or less.

A lower limit of the pressing load in the sintering step S03 is preferably 23 MPa or more, and further preferably 25 MPa or more. On the other hand, an upper limit of the pressing load in the sintering step S03 is preferably 50 MPa or less, and further preferably 45 MPa or less.

(Heat treatment step S04)

Next, after the sintering step S03, a heat treatment is performed to form the aluminum concentrated layer 14.

Here, conditions of the heat treatment step S04 are preferably set such that an atmosphere is an air or a steam atmosphere, a heat treatment temperature is within a range of 500°C or higher and 600°C or lower, and a holding time at the heat treatment temperature is within a range of 5 minutes or more and 15 minutes or less.

According to the above steps, the thermoelectric conversion material 11 according to the present embodiment is manufactured.

According to the thermoelectric conversion material 11 according to the present embodiment having the configuration as above, the aluminum concentrated layer 14 having an Al concentration higher than an aluminum concentration of the inside of the magnesium silicide phase 12 is formed between the magnesium silicide phase 12 including the magnesium silicide and the magnesium oxide layer 13, and the aluminum concentrated layer 14 has the metallic aluminum phase 15 including aluminum or an aluminum alloy. Therefore, with the aluminum concentrated layer 14, invasion of oxygen to the inside of the magnesium silicide phase 12 be suppressed and an oxidation of the magnesium silicide phase 12 be suppressed. Therefore, it is possible to provide the thermoelectric conversion material 11 having excellent oxidation resistance and stable properties.

Furthermore, in the present embodiment, in a case where the thickness of the aluminum concentrated layer 14 is 10 nm or more, the invasion of oxygen to the inside of the magnesium silicide phase 12 can be reliably suppressed by the aluminum concentrated layer 14.

On the other hand, in a case where the thickness of the aluminum concentrated layer 14 is 100 nm or less, the aluminum concentrated layer 14 does not increase the thermal conductivity of the entire thermoelectric element and can be maintained so as not to be higher than the thermal conductivity of the main component. Therefore, a heat exchange efficiency of the thermoelectric conversion module 1 can be improved.

Further, since the thermoelectric conversion element 10 and the thermoelectric conversion module 1 according to the present embodiment include the thermoelectric conversion material 11 described above having excellent oxidation resistance, various properties are stabilized. Therefore, the thermoelectric conversion performance is stable, and the reliability is excellent.

As described above, the embodiments of the present invention are described. However, the present invention is not limited thereto, and can be appropriately modified without departing from the technical idea of the present invention.

For example, in the present embodiment, it was described that the thermoelectric conversion module having a structure as shown in Fig. 1 are configured. However, the present invention is not limited thereto, and there is no particular limitation on a structure and disposition of the electrodes or terminals, as long as the thermoelectric conversion material of the present embodiment is used.

Further, in the present embodiment, it was described that the sintering is performed using the sintering apparatus (electric sintering apparatus 100) shown in Fig. 5, but the present invention is not limited thereto, and a method in which the sintering raw material is sintered by pressing while indirectly heating, for example, hot pressing, HIP, or the like may be used.

Further, in the present embodiment, it was described that a powder of the magnesium silicide to which antimony (Sb) is added as a dopant is used as the sintering raw material, but the present invention is not limited thereto. For example, one or more selected from Li, Na, K, B, Ga, In, N, P, As, Sb, Bi, Ag, Cu, and Y may be contained as the dopant, or these elements may be contained in addition to Sb.

In addition, a sintered body of the non-doped magnesium silicide having no dopant may be used.

Examples

Hereinafter, results of experiments performed to confirm the effects of the present invention will be described.

Mg with a purity of 99.9 mass% (particle size of 180 $\mu$m, manufactured by Kojundo Chemical Lab. Co., Ltd.), Si with a purity of 99.99 mass% (particle size of 300 $\mu$m, manufactured by Kojundo Chemical Lab. Co., Ltd.), and Sb with a purity of 99.9 mass% (particle size of 300 $\mu$m, manufactured by Kojundo Chemical Lab. Co., Ltd.) were prepared, weighed, mixed well in a mortar, placed in an alumina crucible and heated at 850°C for 2 hours in Ar-3vol% $H_2$. In consideration of deviation from Mg:Si = 2:1 of a stoichiometric composition due to sublimation of Mg, Mg was mixed by 5 at% more. Accordingly, a massive magnesium silicide ($Mg_2Si$) having a composition shown in Table 1 was obtained.

Next, this massive magnesium silicide ($Mg_2Si$) was finely pulverized in a mortar, and this was classified to obtain a magnesium silicide powder ($Mg_2Si$ powder) having an average particle size of 30 $\mu$m.

Also, a metallic aluminum powder (purity 99.9 mass%, particle size of 10 $\mu$m) was prepared, and a predetermined amount of magnesium silicide powder and the metallic aluminum powder were weighed and mixed to obtain a sintering raw material powder.

A carbon mold whose inside was covered with a carbon sheet was filled with the obtained sintering raw material powder. Thus, electric sintering was performed by the sintering apparatus (electric sintering apparatus 100) shown in Fig. 5 in conditions shown in Table 1.

Moreover, a measurement specimen was taken from the obtained thermoelectric conversion material, and a content of aluminum in the thermoelectric conversion material was measured by a fluorescent X-ray analysis method (scanning type X-ray fluorescence spectrometer ZSX Primus II manufactured by Rigaku Corporation). Table 1 shows measurement results.

In addition, the obtained thermoelectric conversion material was observed as follows, and the presence or absence of the metallic aluminum phase in the aluminum concentrated layer, the Al concentration ratio with the magnesium silicide phase, the thickness of the aluminum concentrated layer, and the oxide film thickness were evaluated. Table 2 shows evaluation results.

The thermoelectric conversion material was placed in a photoelectron spectrometer (ULVAC-PHI PHI 5000 Versa Probe 2), and binding energies of Mg2p, Si2p, Al2p, and O1s were analyzed. For an analysis condition, 50 W monochromated AlK alpha rays were used as an X-ray source. A measurement area is 200 $\mu$m $\times$ 200 $\mu$m. Thereafter, etching was performed for 1 minute with Ar ions, and the binding energies of Mg, Si, Al, and O were analyzed again. This operation was repeatedly carried out, a bonding state of atoms was evaluated from changes in the concentration of each element in a depth direction and the changes in the binding energies. The Ar ion etching conditions were such that an ion acceleration voltage was 2.0 kV and a raster width was 2.4 mm $\times$ 2.4 mm. The etching depth was determined as follows. A silicon oxide film having a defined film thickness was formed on a Si wafer, and a sputtering rate of the silicon oxide film was first determined. The etching depth was determined by assuming that the etching rate of MgO was half that of the silicon oxide film.

Regarding the presence or absence of the metallic aluminum phase in the aluminum concentrated layer, a case where the Al concentration of 1.5 times or more the Al concentration at a depth of 500 nm was detected was evaluated as "Presence".

Regarding the thickness of the aluminum concentrated layer, the range in which the Al concentration was 1.5 times or more the Al concentration at the depth of 500 nm was defined as the aluminum concentrated layer.

The Al concentration ratio with the magnesium silicide phase was defined as (peak concentration of Al concentration in aluminum concentrated layer)/(Al concentration at depth of 500 nm).

The oxide film thickness was set to a depth at which the oxygen concentration was 90 at% or lower of the concentration at the outermost surface concentration.

[Table 1]

| | Magnesium silicide | Content of aluminum (mass%) | Sintering condition | | | |
|---|---|---|---|---|---|---|
| | | | Atmosphere | Sintering temperature (°C) | Holding time (Second(s)) | Pressing load (MPa) |
| Present Example 1 | Sb-doped (1 at%) | 0.01 | Vacuum | 950 | 60 | 30 |
| Present Example 2 | Sb-doped (1 at%) | 0.11 | Vacuum | 950 | 60 | 30 |
| Present Example 3 | Sb-doped (1 at%) | 0.98 | Vacuum | 950 | 60 | 30 |
| Present Example 4 | Non-doped | 0.01 | Vacuum | 950 | 60 | 30 |
| Present Example 5 | Non-doped | 0.12 | Vacuum | 950 | 60 | 30 |
| Present Example 6 | Non-doped | 0.99 | Vacuum | 950 | 60 | 30 |
| Comparative Example 1 | Sb-doped (1 at%) | - | Vacuum | 950 | 60 | 30 |
| Comparative Example 2 | Non-doped | - | Vacuum | 950 | 60 | 30 |

[Table 2]

| | Aluminum concentrated layer | | | Oxide film thickness (nm) |
|---|---|---|---|---|
| | Presence or absence of metallic aluminum phase | Al concentration ratio with the magnesium silicide phase | Thickness (nm) | |
| Present Example 1 | Presence | 1.7 | 11 | 55 |
| Present Example 2 | Presence | 2.8 | 47 | 43 |
| Present Example 3 | Presence | 5.9 | 95 | 32 |
| Present Example 4 | Presence | 1.6 | 10 | 53 |
| Present Example 5 | Presence | 2.9 | 51 | 41 |
| Present Example 6 | Presence | 6.0 | 98 | 30 |
| Comparative Example 1 | Absence | 1.0 | 0 | 209 |
| Comparative Example 2 | Absence | 1.0 | 0 | 215 |
| ※ Relative evaluation in a case where Comparative Example 1 is defined as 1. | | | | |

In Comparative Example 1 in which Sb-doped magnesium silicide was used for formation without containing aluminum, the aluminum concentrated layer was not formed, and the oxide film thickness was as thick as 209 nm.

In Comparative Example 2 in which non-doped magnesium silicide was used for formation without containing aluminum, the aluminum concentrated layer was not formed, and the oxide film thickness was as thick as 215 nm.

On the other hand, in Present Examples 1-6 in which aluminum was contained and an aluminum concentrated layer was formed and a metallic aluminum phase was confirmed in the aluminum concentrated layer, the oxide film thickness was suppressed to 55 nm or less.

From the above, it was confirmed that, according to the Present Examples, it is possible to provide a thermoelectric conversion material which includes a sintered body containing a magnesium silicide as a main component and has excellent oxidation resistance.

[Industrial Applicability]

It is possible to provide a thermoelectric conversion module which includes a sintered body containing a magnesium silicide as a main component, has an excellent oxidation resistance, and has an excellent thermoelectric conversion efficiency.

[Reference Signs List]

1 Thermoelectric conversion module
10 Thermoelectric conversion element
11 Thermoelectric conversion material
12 Magnesium silicide phase
13 Magnesium oxide layer
14 Aluminum concentrated layer
15 Metallic aluminum phase
18a, 18b Electrode
19a, 19b Terminal

**Claims**

1.  A thermoelectric conversion material made of a sintered body containing a magnesium silicide as a major component, the thermoelectric conversion material comprising:

    a magnesium silicide phase; and
    a magnesium oxide layer formed on a surface layer of the magnesium silicide phase,
    wherein an aluminum concentrated layer having an Al concentration higher than an aluminum concentration in an inside of the magnesium silicide phase is formed between the magnesium oxide layer and the magnesium silicide phase, and
    the aluminum concentrated layer has a metallic aluminum phase made of aluminum or an aluminum alloy.

2.  The thermoelectric conversion material according to claim 1,
    wherein a thickness of the aluminum concentrated layer is within a range of 10 nm or more and 100 nm or less.

3.  The thermoelectric conversion material according to claim 1 or 2,
    wherein the magnesium silicide phase is formed of a non-doped magnesium silicide.

4.  The thermoelectric conversion material according to claim 1 or 2,
    wherein the magnesium silicide phase is formed of a magnesium silicide containing, as a dopant, one or more selected from Li, Na, K, B, Ga, In, N, P, As, Sb, Bi, Ag, Cu, and Y.

5.  A thermoelectric conversion element comprising:

    the thermoelectric conversion material according to any one of claims 1 to 4; and
    electrodes respectively joined to one surface and an other surface of the thermoelectric conversion material.

6.  A thermoelectric conversion module comprising:

    the thermoelectric conversion element according to claim 5; and
    terminals respectively joined to the electrodes of the thermoelectric conversion element.

# FIG. 1

# FIG. 2

FIG. 3

# FIG. 4

# FIG. 5

<table>
<tr><td colspan="2">INTERNATIONAL SEARCH REPORT</td><td>International application No.<br>PCT/JP2019/044313</td></tr>
</table>

**A. CLASSIFICATION OF SUBJECT MATTER**
H01L 35/14(2006.01)i; C01B 33/06(2006.01)i; C04B 35/58(2006.01)i
FI: H01L35/14; C01B33/06; C04B35/58 085
According to International Patent Classification (IPC) or to both national classification and IPC

**B. FIELDS SEARCHED**

Minimum documentation searched (classification system followed by classification symbols)
H01L35/14; C01B33/06; C04B35/58

Documentation searched other than minimum documentation to the extent that such documents are included in the fields searched
| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)
JSTPlus/JSTChina/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| A | WO 2017/146095 A1 (MITSUBISHI MATERIALS CORP.) 31.08.2017 (2017-08-31) entire text, all drawings | 1-6 |
| A | JP 2011-249742 A (SANTOKU CORPORATION) 08.12.2011 (2011-12-08) entire text, all drawings | 1-6 |
| A | JP 2018-186136 A (OSAKA UNIVERSITY) 22.11.2018 (2018-11-22) entire text, all drawings | 1-6 |
| A | JP 2016-207825 A (TOYOTA BOSHOKU CORP.) 08.12.2016 (2016-12-08) entire text, all drawings | 1-6 |
| A | JP 2002-368291 A (TOKYO YOGYO CO., LTD.) 20.12.2002 (2002-12-20) entire text, all drawings | 1-6 |
| A | JP 2016-178319 A (HITACHI CHEMICAL COMPANY, LTD.) 06.10.2016 (2016-10-06) entire text, all drawings | 1-6 |

☒ Further documents are listed in the continuation of Box C.    ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 24 January 2020 (24.01.2020) | 04 February 2020 (04.02.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

International application No.

PCT/JP2019/044313

| C (Continuation). | DOCUMENTS CONSIDERED TO BE RELEVANT | |
|---|---|---|
| Category* | Citation of document, with indication, where appropriate, of the relevant passages | Relevant to claim No. |
| A | JP 2011-049538 A (TOKYO UNIVERSITY OF SCIENCE) 10.03.2011 (2011-03-10) entire text, all drawings | 1-6 |
| A | JP 2016-219666 A (TOYOTA MOTOR CORP.) 22.12.2016 (2016-12-22) entire text, all drawings | 1-6 |
| A | JP 2009-094497 A (TOYOTA INDUSTRIES CORPORATION) 30.04.2009 (2009-04-30) entire text, all drawings | 1-6 |
| P, A | JP 2019-012828 A (MITSUBISHI MATERIALS CORP.) 24.01.2019 (2019-01-24) entire text, all drawings | 1-6 |
| P, A | JP 2019-012717 A (MITSUBISHI MATERIALS CORP.) 24.01.2019 (2019-01-24) entire text, all drawings | 1-6 |

Form PCT/ISA/210 (continuation of second sheet) (January 2015)

**EP 3 905 350 A1**

INTERNATIONAL SEARCH REPORT
Information on patent family members

International application No.

PCT/JP2019/044313

| Patent Documents referred in the Report | Publication Date | Patent Family | Publication Date |
|---|---|---|---|
| WO 2017/146095 A1 | 31 Aug. 2017 | US 2019/0067548 A1 entire text, all drawings EP 3422428 A1 CN 108701749 A KR 10-2018-0114892 A TW 201803999 A JP 2017-152691 A | |
| JP 2011-249742 A | 08 Dec. 2011 | (Family: none) | |
| JP 2018-186136 A | 22 Nov. 2018 | (Family: none) | |
| JP 2016-207825 A | 08 Dec. 2016 | (Family: none) | |
| JP 2002-368291 A | 20 Dec. 2002 | (Family: none) | |
| JP 2016-178319 A | 06 Oct. 2016 | US 2013/0061901 A1 entire text, all drawings DE 102012017556 A1 CN 103000798 A | |
| JP 2011-049538 A | 10 Mar. 2011 | US 2012/0118343 A1 entire text, all drawings US 2015/0207056 A1 WO 2011/013609 A1 EP 2461384 A1 TW 201127966 A CN 102473831 A KR 10-2012-0049286 A | |
| JP 2016-219666 A | 22 Dec. 2016 | (Family: none) | |
| JP 2009-094497 A | 30 Apr. 2009 | (Family: none) | |
| JP 2019-012828 A | 24 Jan. 2019 | WO 2019/004373 A1 entire text, all drawings TW 201904915 A CN 110366784 A | |
| JP 2019-012717 A | 24 Jan. 2019 | (Family: none) | |

Form PCT/ISA/210 (patent family annex) (January 2015)

18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018242588 A
- JP 2013179322 A
- JP 2017050325 A